# EUROPÄISCHE PATENTSCHRIFT

(11) **EP 2 091 308 B1**
(45) Veröffentlichungstag und Bekanntmachung des Hinweises auf die Patenterteilung: **13.03.2019**
(21) Anmeldenummer: 08172494.0
(22) Anmeldetag: 22.12.2008
(51) Int. Cl.: H05K 1/18

(54) **Schaltung mit integrierter Abschirmung und Hörhilfe**
Switching with integrated shielding and hearing aid
Commutation dotée d'un blindage intégré et aide auditive

(30) Priorität: 13.02.2008 DE 102008008897
(43) Veröffentlichungstag der Anmeldung: 19.08.2009
(73) Patentinhaber: Sivantos Pte. Ltd., Singapore 539775 (SG)
(72) Erfinder: Chew, Leep Foong, 680541, Singapore (SG); Kang, Raymond, 768452, Singapore (SG); Lim, Meng Kiang, 310060, Singapore (SG); Yap, Chow Lan Stella, 574036, Singapore (SG)
(74) Vertreter: FDST Patentanwälte

(56) Entgegenhaltungen:
- GB-A- 2 173 048
- US-A- 4 912 769
- US-A- 4 922 059
- US-A- 5 031 027
- US-A1- 2006 043 562
- US-A1- 2006 067 070
- DE JONG E C W ET AL: "3D Integration with PCB Technology" APPLIED POWER ELECTRONICS CONFERENCE AND EXPOSITION, 2006. APEC '06. T WENTY-FIRST ANNUAL IEEE MARCH 19, 2006, PISCATAWAY, NJ, USA,IEEE, 19. März 2006 (2006-03-19), Seiten 857-863, XP010910045 ISBN: 978-0-7803-9547-3

## Beschreibung

Die Erfindung betrifft eine flexible Leiterplatte mit integrierter Abschirmung und eine darauf basierte Schaltung sowie eine Hörhilfe mit einer solchen Schaltung.

Hörhilfen werden eingesetzt, um einen Hörverlust des Hörhilfeträgers zu kompensieren. Sie sollen dies möglichst fehlerfrei in sehr unterschiedlichen Situationen und Umgebungen tun. Um in verschiedenen Geräuschumgebungen eine brauchbare Hörunterstützung liefern zu können, ist die Verwendung jeweils angepasster Hörprogramme und adaptiver Filter üblich. Diese und weitere Funktionen, wie die Unterdrückung von Rückkopplungen oder Rauschen, erfordern eine umfangreiche und komplexe elektronische Steuerung.

Die elektronische Steuerung ist meist als digitale Schaltung ausgeführt. Im Umfeld der Steuerung, vor allem im Bereich der Signaleingänge und Signale ausgingen, finden sich auch analoge Schaltungsteile und Signale. Auch in der Umgebung der Hörhilfe beziehungsweise das Hörhilfeträgers treten zahlreiche elektrische, meist analoge, Signale auf. Sämtliche elektromagnetischen Signale im Umfeld der Steuerung sowie in der Umgebung der Hörhilfe können sich auf die Funktion der Steuerung als Störeinflüsse auswirken. Man spricht von EMI (ElectroMagnetic Interference).

Um den Einfluss elektromagnetischer Störsignale auf die Funktion der Steuerung zu unterbinden oder zumindest zu verringern, ist es bekannt, Maßnahmen zur elektromagnetischen Abschirmung zu treffen. Zum Beispiel können Teile des Gehäuses der Hörhilfe oder das ganze Gehäuse mit einer elektrisch leitfähigen, abschirmenden Beschichtung versehen werden. Stattdessen kann das Gehäuse aus einem Material mit abschirmenden Eigenschaften hergestellt werden. Dadurch können zwar elektromagnetische Signale von außerhalb des Gehäuses abgeschirmt oder zumindest reduziert werden. Wegen der Öffnungen für das Mikrophon sowie den Receiver verbleiben jedoch zwangsläufig stellen, an denen Störsignale das Gehäuse passieren können. Zudem sind häufig Möglichkeiten vorgesehen, die Hörhilfe kabellos zu programmieren oder erwünschte elektromagnetische Signale beispielsweise zu einer Telefonspule im Innern des Gehäuses gelangen zu lassen. Hierfür sind ebenfalls Abschirm-Fenster im Gehäuse erforderlich. Eine möglichst wirksame Abschirmung der Steuerung ist deshalb durch das Gehäuse nicht erreichbar.

Aus der JP 2003-142875 A und aus der JP 2004-128418 A sind Schaltungen für Mobiltelefone bekannt, bei denen Abschirmelemente in den jeweiligen Schaltungsträger integriert sind. Die Abschirmelemente sind jeweils auf Abschnitten der Schaltungsträger vorgesehen, welche keine Leiterbahnen oder elektrischen Komponenten tragen. Die Schaltungsträger bestehen aus flexiblem Material und werden so gebogen, dass die Abschirmelemente über oder unter den abzuschirmenden Schaltungskomponenten angeordnet sind. Auf diese Weise wird eine Abschirmung der Schaltung in genau eine Richtung erreicht.

Aus dem Dokument DE 43 03 908 A1 ein Gehäuse eines Steuergeräts für ein Kraftfahrzeug bekannt, das eine dreigeteilte, flexible Leiterplatte umfasst. Auf zwei Teilen der Leiterplatte sind Aluplatten befestigt, die auf den Rahmen des Gehäuses geklappt werden. Dadurch wird das Gehäuse verschlossen und gegen hochfrequente Strahlung abgeschirmt.

Aus der Druckschrift US 2006/0067070 A1 ist ein RF-Modul bekannt, das eine flexible bedruckte Leiterplatte umfasst. Die Leiterplatte umfasst eine als Abschirmung dienende Metallisierung. Sie ist um die darauf montierten elektronischen Komponenten mit offenbleibenden Stoßkanten herumgefaltet und schirmt die Komponenten zumindest teilweise ab. Eine ähnliche Anordnung ist aus der Druckschrift US 4,922,059 A1 bekannt, bei der ebenfalls eine zur Abschirmung ausgebildete Leiterplatte mit offenen Stoßkanten gefaltet ist.

Aus der Druckschrift US 5,031,027 A ist eine flexible Leiterplatte bekannt, die zumindest teilweise eine Abschirmschicht umfasst. Die Leiterplatte ist zu einer Schaltung gefaltet, die eine abschirmende Umhüllung um eine darauf angeordnete Schaltung bildet.

Elektromagnetische Störsignale sind in aller Regel nicht auf eine Ursprungsrichtung beschränkt. Je nach Umgebung können unterschiedlichste Quellen für Störsignale in vielen Richtungen auftreten. Hinzu kommen können möglicherweise auftretende Reflexionen sowie die Tatsache, dass die jeweilige Schaltung möglicherweise in einem mobilen Gerät eingesetzt ist, das vom Benutzer laufend bewegt und rotiert wird. Dies gilt für Schaltungen in Hörhilfen ebenso wie in Mobiltelefonen und einer Vielzahl weiterer Anwendungen. Durch die Vielzahl elektronischer Geräte in alltäglichen Umgebungen ist eine ebensolche Vielzahl von Anwendungsfällen gegeben, in denen ein Bedarf zur wirksameren Abschirmung elektronischer Schaltungen besteht.

Die der Erfindung zugrundeliegende Aufgabe besteht darin, eine Abschirmung für elektronische Schaltungen, insbesondere für Steuerung einer Hörhilfe, gegen elektromagnetische Störsignale anzugeben, die wirksamer und zugleich weniger aufwändig in der Herstellung ist.

Die Erfindung löst diese Aufgabe durch eine flexible Leiterplatte sowie durch eine Schaltung und durch eine Hörhilfe mit den Merkmalen der Patentansprüche 1, 6 und 12.

Der Vorteil ergibt sich, dass die Leiterplatte mit integrierten Abschirmbereichen einstückig und ohne zusätzliche Arbeitsschritte herstellbar ist. Durch die nachfolgend beschriebene Herstellung einer Schaltung unter Verwendung einer solchen Leiterplatte ist eine in mehreren Raumrichtungen gegen Störsignale abgeschirmte Schaltung unaufwändig herzustellen, ohne dass in zusätzlichen Arbeitsschritten eine separate Abschirmvorrichtung hinzugefügt werden müsste. Durch den Wegfall einer separaten Abschirmvorrichtung ergibt sich darüber hinaus auch eine Platz sparende und weniger komplexe Schaltung.

Erfindungsgemäß weist die flexible Leiterplatte drei unterschiedliche Biegebereiche auf, in denen sie um je eine Biegeachse biegbar ist, wobei zwei Biegeachsen parallel zueinander und senkrecht zu der dritten Biegeachse stehen, und wobei die Abschirmschicht sich mindestens über die drei Biegebereiche erstreckt. In einer weiteren bevorzugten Ausführungsform weist sie einen im wesentlichen T-förmigen Grundriss auf.

Dadurch ergibt sich der Vorteil, dass durch Biegen der Leiterplatte um die Biegebereiche eine Schaltung erzeugt wird, die in mindestens fünf Richtungen gegen elektromagnetische Störeinflüsse abgeschirmt ist. Elektrische Komponenten können so auf der Leiterplatte angeordnet sein, dass sie von den Biegebereichen beziehungsweise Abschirmbereichen in fünf Raumrichtungen gegen Störsignale abgeschirmt werden.

Wird ein weiterer, gegebenenfalls als Abschirmbereich ausgeführter, Biegebereich vorgesehen, kann eine Abschirmung in sechs Raumrichtungen erreicht werden. Entsprechende Anordnung der Biegebereiche beziehungsweise Abschirmbereiche vorausgesetzt kann so ein umschlossener Raum erreicht werden, der in sämtlichen Richtungen gegen Störsignale abgeschirmt ist.

Erfindungsgemäß ist die Leiterplatte in mindestens drei unterschiedlichen Biegebereichen um je eine Biegeachse biegbar, wobei zwei Biegeachsen parallel zueinander und senkrecht zu der dritten Biegeachse stehen. Die Leiterplatte trägt in mindestens einem Schaltungsbereich elektronische Bauelemente. Die Abschirmschicht erstreckt sich über mindestens zwei unterschiedliche durch Biegebereiche voneinander getrennte Leiterplattenbereiche sowie über die drei Biegebereiche, und die Leiterplatte ist in den Biegebereichen derart gebogen, dass der Schaltungsbereich durch die Abschirmschicht in mindestens fünf zueinander im wesentlichen senkrechten Richtungen gegen elektromagnetische Störeinflüsse abgeschirmt ist.

In einer weiteren vorteilhaften Ausgestaltung der Erfindung bestehen die Metallisierungsschicht und die Abschirmschicht aus demselben leitfähigen Material. Dies vereinfacht Aufbau und Herstellung der Leiterplatte und damit auch der Schaltung.

In einer weiteren vorteilhaften Ausgestaltung der Erfindung sind die leitfähigen Strukturen der Metallisierungsschicht und die Abschirmschicht durch Entfernen von leitfähigem Material aus derselben leitfähigen Schicht erzeugt. Durch die doppelte Funktion der Metallisierungsschicht beziehungsweise den Verzicht auf eine zusätzliche Schicht wird eine dünnere und flexiblere Leiterplatte erreicht.

In einer vorteilhaften Ausgestaltung der Erfindung ist zur Abschirmung gegen elektromagnetische Störeinflüsse eine Schicht vorgesehen ist, die Gold beinhaltet. Aufgrund seiner elektrischen Eigenschaften ist Gold besonders geeignet für die Verwendung in einer Abschirmschicht sowie in einer Metallisierungsschicht.

In einer weiteren vorteilhaften Ausgestaltung der Erfindung ist die Leiterplatte in den Biegebereichen derart gebogen, dass die Leiterplattenbereiche ein zumindest eine Seite des Schaltungsbereichs umfassendes Schaltungsvolumen umgrenzen, und das Schaltungsvolumen ist ausgegossen. Dadurch wird ein kompakter und stabiler Aufbau einer allseitig gegen elektromagnetische Störsignale abgeschirmten Schaltung erreicht. In einer vorteilhaften Ausgestaltung ist das Schaltungsvolumen mit Epoxidharz ausgegossen.

Ein weiterer Grundgedanke der Erfindung besteht darin, eine Hörhilfe mit einer Schaltung, wie sie vorangehend beschrieben ist, anzugeben.

Weitere vorteilhaften Ausgestaltung der Erfindung ergeben sich aus den abhängigen Patentansprüchen sowie aus den nachfolgend beschriebenen Ausführungsbeispielen. Es zeigen:
- FIG 1: T-förmige Leiterplatte
- FIG 2: T-förmige Leiterplatte einfach gebogen
- FIG 3: T-förmige Leiterplatte zweifach gebogen
- FIG 4: Schaltung aus T-förmiger Leiterplatte
- FIG 5: L-förmige Leiterplatte
- FIG 6: L-förmige Leiterplatte einfach gebogen
- FIG 7: Schaltung aus L-förmiger Leiterplatte
- FIG 8: Leiterplatte mit getrennter Abschirmschicht und Metallisierungsschicht
- FIG 9: Leiterplatte mit gemeinsamer Abschirmschicht und Metallisierungsschicht
- FIG 10: Hörhilfe

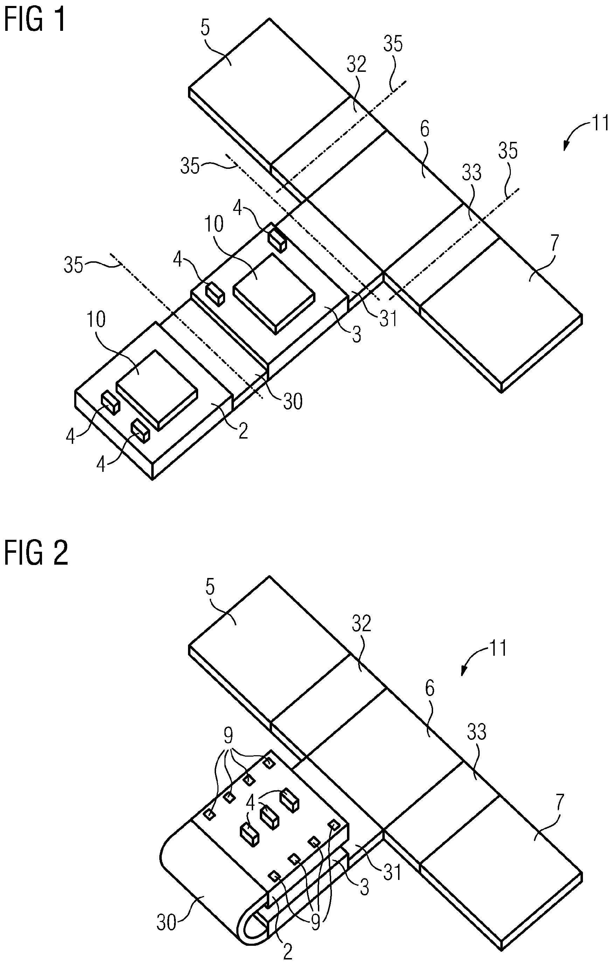

In **FIG 1** ist eine T-förmige flexible Leiterplatte 11 mit integrierter Abschirmung schematisch dargestellt. Die Leiterplatte 11 weist Schaltungsbereiche 2, 3 auf, die elektronische Komponenten tragen. Neben nicht dargestellten Leiterbahnen sind dies SMD-Elemente 4 und ICs 10. Schaltungsbereich 2 ist vom Schaltungsbereich 3 durch einen Biegebereich 30 getrennt, der ausreichend flexibel ist, um eine hohe Biege-Variabilität zu gewährleisten. Durch den Grundriss des Biegebereichs 30 ergibt sich eine Vorzugsrichtung für eine Biegung, die entlang der Biegeachse 35 verläuft.

Ein weiterer Biegebereich 31 trennt den Schaltungsbereich 3 von Leiterplattenbereich 6. Weitere Biegebereiche 32, 33 trennen den Leiterplattenbereich 6 von weiteren Leiterplattenbereichen 5, 7. Dabei sind die Biegebereiche 32, 33 beziehungsweise deren Biegeachsen 35 parallel zueinander angeordnet und senkrecht zum Biegebereich 31. Es ergibt sich ein T-förmiger Grundriss für die Leiterplatte 11. Die Biegebereiche 31, 32, 33 sind jeweils durch Biegeachsen 35 gekennzeichnet und gewährleisten jeweils eine hohe Biege-Variabilität.

In die flexible Leiterplatte 11 integriert ist eine Abschirmschicht, die eine Abschirmung oder zumindest Reduzierung elektromagnetischer Störsignale (EMI) bewirkt. Die Abschirmschicht ist in den Schichtaufbau der Leiterplatte 11 als eigene Schicht oder als Schichtbestandteil oder als Beschichtung integriert und in der Figur nicht darstellbar. Sie erstreckt sich über die Biegebereiche 31, 32, 33 sowie zusätzlich über die Leiterplattenbereiche 5, 6, 7.

Je nach Ausführung der Leiterplatte 11 und je nach Verwendungszweck kann sich die Abschirmschicht auch lediglich über die Biegebereiche 31, 32, 33 erstrecken oder zusätzlich dazu lediglich über einige der Leiterplattenbereiche 5, 6, 7.

In **FIG 2** ist die vorangehend beschriebene Leiterplatte 11 dargestellt, wobei der Schaltungsbereich 2 um den Biegebereich 30 herum gebogen ist. Schaltungsbereich 2 ist dadurch über dem Schaltungsbereich 3 angeordnet, und zwar so, dass die Unterseite von Schaltungsbereich 2 nach oben gekehrt ist. Die Unterseite trägt SMD-Elemente 4 sowie Bontpads 9.

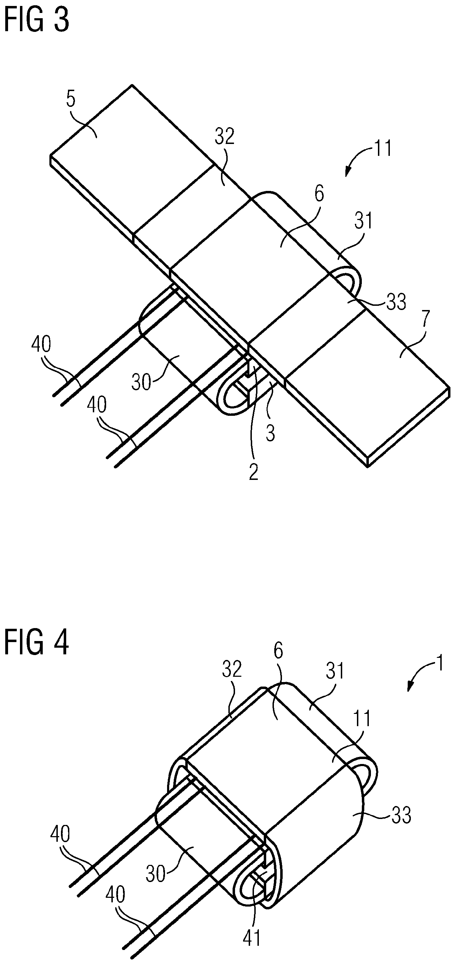

In **FIG 3** ist die Leiterplatte 11 erneut dargestellt, wobei die Leiterplattenbereiche 5, 6, 7 (der obere Balken des T) um den Biegebereich 31 herum gebogen sind. Dadurch sind sie über dem Schaltungsbereich 2 angeordnet, und zwar mit der Unterseite nach oben gekehrt. Zusätzlich sind Bonddrähte 40 dargestellt, die mit den Bondpads 9 verbondet wurden.

In **FIG 4** ist die Leiterplatte 11 erneut dargestellt, wobei die Leiterplattenbereiche 5, 7 um die Biegebereiche 32, 33 herum unter denen Schaltungsbereich 3 gebogen sind. Somit ist die endgültige Konfiguration der Leiterplatte 11 erreicht. Die Leiterplatte 11 umschließt so das Schaltungsvolumen 41. Die Außenwände werden durch die Leiterplattenbereiche 6 und 5 bzw. 7 (je nach Biege-Reihenfolge) sowie durch die Biegebereiche 30, 31, 32, 33 gebildet.

In dieser endgültigen Konfiguration bildet die Leiterplatte 11 die Schaltung 1. Aufgrund dessen, dass die Schaltung 1 durch Biegen (oder auch: Falten) der Leiterplatte 11 gebildet wurde, wird diese Technik auch als Origami bezeichnet.

Das umschlossene Schaltungsvolumen 41 wird mit Epoxidharz ausgegossen. Dadurch erhält die aus der Leiterplatte 11 entstandene Schaltung 1 Stabilität. Außerdem werden die elektronischen Komponenten im umschlossenen Schaltungsvolumen 41 (SMD-Elemente 4, ICs 10) eingekapselt und elektrisch isoliert.

Dadurch, dass sich die Abschirmschicht über die außenliegenden Biegebereiche 30, 31, 32, 33 sowie die außenliegenden Leiterplattenbereiche 6 und 5 bzw. 7 erstreckt, ist das umschlossene Schaltungsvolumen 41 mit den darinliegenden elektronischen Komponenten gegen elektromagnetische Störsignale abgeschirmt.

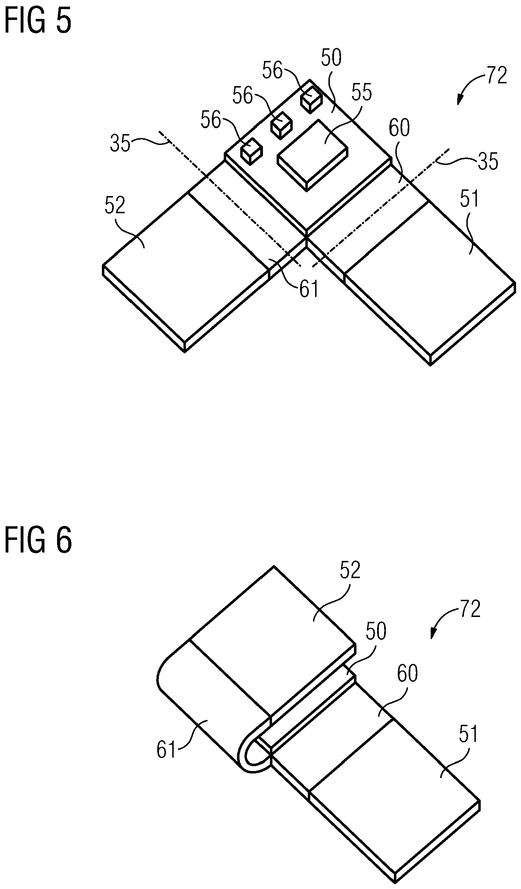

Bei der L-förmigen Leiterplatte der Abbildungen 5 bis 7 handelt es sich um ein Beispiel, das nicht Teil der Erfindung ist. In **FIG 5** ist eine L-förmige flexible Leiterplatte 72 mit integrierter Abschirmung schematisch dargestellt. Die Leiterplatte 72 weist einen Schaltungsbereich 50 auf, der elektronische Komponenten tragen. Neben nicht dargestellten Leiterbahnen sind dies SMD-Elemente 56 und ein IC 55. Schaltungsbereich 50 ist von den Leiterplattenbereichen 51, 52 durch Biegebereiche 60, 61 getrennt. Die Biegebereiche sind ausreichend flexibel, um eine hohe Biege-Variabilität zu gewährleisten. Durch den Grundriss der Biegebereichs 60, 61 ergibt sich jeweils eine Vorzugsrichtung für eine Biegung, die entlang der Biegeachsen 35 verläuft.

Dabei sind die Biegebereiche 60, 61 beziehungsweise deren Biegeachsen 35 senkrecht zueinander angeordnet. Es ergibt sich ein L-förmiger Grundriss der Leiterplatte 72.

In die flexible Leiterplatte 72 integriert ist eine Abschirmschicht, die eine Abschirmung oder zumindest Reduzierung elektromagnetischer Störsignale (EMI) bewirkt. Die Abschirmschicht ist in den Schichtaufbau der Leiterplatte 72 als eigene Schicht oder als Schichtbestandteil oder als Beschichtung integriert und in der Figur nicht darstellbar. Sie erstreckt sich über die Biegebereiche 60, 61 sowie zusätzlich über einen der beiden Leiterplattenbereiche 51, 52.

Je nach Ausführung der Leiterplatte 11 und je nach Verwendungszweck kann sich die Abschirmschicht auch lediglich über die Biegebereiche 60, 61 erstrecken oder zusätzlich dazu lediglich über beide Leiterplattenbereiche 51, 52.

In **FIG 6** ist die vorangehend beschriebene Leiterplatte 72 dargestellt, wobei der Leiterplattenbereich 52 um den Biegebereich 61 herum gebogen ist. Leiterplattenbereich 52 ist dadurch über dem Schaltungsbereich 50 angeordnet, und zwar mit der Unterseite von Leiterplattenbereich 52 nach oben gekehrt.

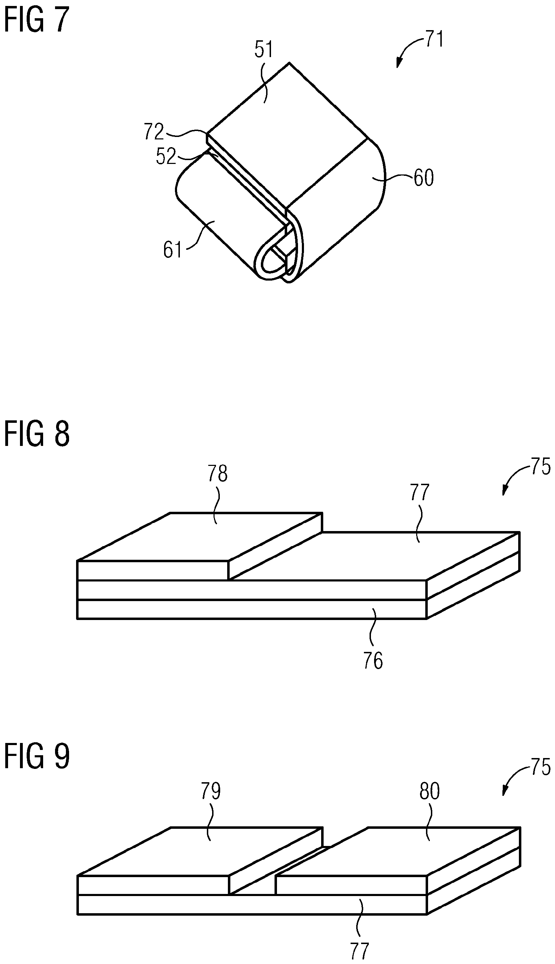

In **FIG 7** ist die vorangehend beschriebene Leiterplatte 72 erneut dargestellt, wobei der Leiterplattenbereich 51 um den Biegebereich 60 herum gebogen ist. Leiterplattenbereich 51 ist dadurch über dem Leiterplattenbereich 52 sowie über dem Schaltungsbereich 50 angeordnet, und zwar mit der Unterseite nach oben gekehrt.

Somit ist die endgültige Konfiguration der Leiterplatte 72 erreicht, in der sie ein Schaltungsvolumen in 4 Raumrichtungen umschließt. Dies sind in der Darstellung die dem Betrachter zugewandten Raumrichtungen, die abgewandten Raumrichtungen sind nicht umschlossen. Die Außenwände des umschlossenen Schaltungsvolumens werden durch den Leiterplattenbereich 51 sowie durch die Biegebereiche 60, 61 gebildet.

In dieser endgültigen Konfiguration bildet die Leiterplatte 72 die Schaltung 71. Dadurch, dass sich die Abschirmschicht über die außenliegenden Biegebereiche 60, 61 sowie den außenliegenden Leiterplattenbereich 51 oder 52 erstreckt, ist das umschlossene Schaltungsvolumen mit den darinliegenden elektronischen Komponenten in 3 Raumrichtungen gegen elektromagnetische Störsignale abgeschirmt.

In **FIG 8** ist eine flexible Leiterplatte 75 schematisch dargestellt. Sie umfasst eine elektrisch isolierende Trägerschicht 77 sowie eine darunterliegende Abschirmschicht 76. Die Abschirmschicht 76 ist aus einem elektrisch leitfähigen, für Abschirm-Zwecke geeigneten Material gebildet beziehungsweise umfasst dieses. Vorzugsweise kommen Kupfer oder Gold in Betracht. Die Metallisierungsschicht 78, aus der die Leiterbahnen üblicherweise durch lithographische Verfahren erzeugt werden, liegt oberhalb der Trägerschicht 77. Mit dieser Anordnung von Metallisierungsschicht 78, Trägerschicht 77 und Abschirmschicht 76 kann eine vollständige Abschirmung der gesamten Leiterplatten-Fläche gegen elektromagnetische Störsignale erreicht werden, auch auf der dem Schaltungsbereich rückwärtig gegenüberliegenden Fläche.

In **FIG 9** ist eine flexible Leiterplatte 75 schematisch dargestellt, deren Schichtaufbau um eine Lage reduziert ist. Oberhalb einer Trägerschicht 77 ist eine Metallisierungsschicht 79 sowie eine Abschirmschicht 80 angeordnet. Im Schichtaufbau sind Metallisierungsschicht 79 und Abschirmschicht 80 in ein und der selben Lage angeordnet. Diese Lage des Schichtaufbaus basiert auf einem Material, das zur Erzeugung von Leiterbahnen ebenso geeignet ist, wie zur Erzeugung einer Abschirmung. Vorzugsweise kommen Kupfer oder Gold in Betracht. Durch lithographische Verfahren werden zum einen die Leiterbahnen der Metallisierungsschicht 79 gebildet, zum anderen die Abschirmschicht 80 von der Metallisierungsschicht 79 getrennt. Eine derart aufgebaute Leiterplatte weist aufgrund der geringeren Anzahl von Lagen eine höhere Flexibilität auf, ist dafür jedoch nicht über die gesamte Fläche hinweg gegen elektromagnetische Störsignale abgeschirmt.

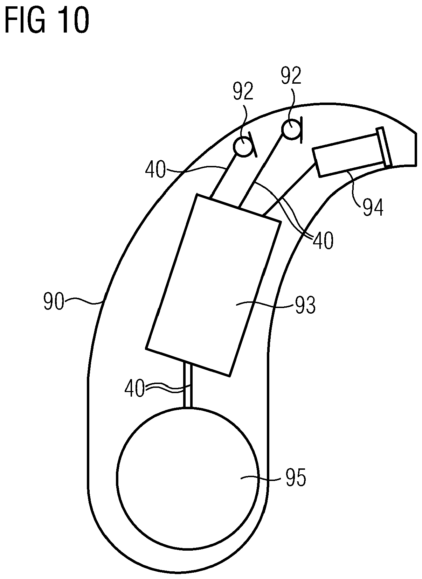

In **FIG 10** ist eine Hörhilfe 90 schematisch dargestellt. Innerhalb des Gehäuses der Hörhilfe 90 befindet sich eine Batterie 95, die die zum Betrieb der elektrischen Schaltung 93 erforderliche elektrische Energie liefert. Die elektrische Schaltung 93 dient der Steuerung der Hörhilfe 90 beziehungsweise des Betriebs und der Funktionen, z.B. der Hörprogramme. Neben der Batterie 5 sind mit der Schaltung 93 daher Mikrophone 92 sowie der Receiver 94 verbunden.

Die Schaltungsziffer 93 ist gegen elektromagnetische Störsignale sowohl von außerhalb des Gehäuses als auch von den Komponenten innerhalb des Gehäuses abgeschirmt. Um diese Abschirmung zu erreichen, ist sie in die vorangehend in Zusammenhang mit FIG 4 bzw. FIG 7 beschrieben ausgeführt.

Die Erfindung lässt sich wie folgt zusammenfassen: Die Erfindung betrifft eine flexible Leiterplatte mit den Merkmalen des Patentanspruchs 1, eine darauf basierte Schaltung sowie eine Hörhilfe mit einer solchen Schaltung. Eine Schaltung auf Basis einer solchen Leiterplatte trägt in zwei Schaltungsbereichen elektronische Bauelemente und kann derart in den Biegebereichen gebogen sein, dass die Schaltungsbereiche durch die Abschirmschicht in mindestens fünf Raumrichtungen gegen elektromagnetische Störeinflüsse abgeschirmt sind.

## Patentansprüche

1. Flexible Leiterplatte (11, 75) umfassend eine Trägerschicht (77), eine Metallisierungsschicht (78, 79) und eine Abschirmschicht (76, 80) zur Abschirmung gegen elektromagnetische Störeinflüsse, wobei die Leiterplatte (11, 75) in mindestens drei unterschiedlichen Biegebereichen (30, 31, 32, 33 um je eine Biegeachse (35) biegbar ist, wobei zwei Biegeachsen (35) parallel zueinander und senkrecht zu der dritten Biegeachse (35) stehen, und wobei die Abschirmschicht (76, 80) sich mindestens über die drei Biegebereiche (31, 32, 33) erstreckt,
**dadurch gekennzeichnet, dass** die Leiterplatte (11, 75) in zwei durch einen weiteren Biegebereich (30) getrennten Schaltungsbereichen (2, 3) elektronische Bauelemente (4, 10) trägt, und dass die Abschirmschicht (76, 80) sich weiterhin mindestens über drei unterschiedliche durch Biegebereiche (31, 32, 33) von den Schaltungsbereichen (2, 3) und voneinander getrennte Leiterplattenbereiche (6, 5, 7) erstreckt, und dass die Leiterplatte (11, 75) derart ausgeführt ist, dass sie in den Biegebereichen (30, 31, 32, 33) derart gebogen werden kann, dass die Schaltungsbereiche (2, 3) übereinander angeordnet sind und durch die Abschirmschicht (76, 80) in mindestens fünf Raumrichtungen gegen elektromagnetische Störeinflüsse abgeschirmt werden, indem einer der Leiterplattenbereiche (6, 5, 7) oberhalb und die beiden anderen Leiterplattenbereiche (6, 5, 7) unterhalb der Schaltungsbereiche (2,3) angeordnet sind, so dass die Leiterplattenbereiche (6, 5, 7) Außenwände eines umschlossenen Schaltungsvolumens (41) in zwei zueinander fluchtenden Raumrichtungen und die Biegebereiche (30, 31, 32, 33) Außenwände in davon abweichenden Raumrichtungen bilden.

2. Flexible Leiterplatte (11) nach Anspruch 1,
**dadurch gekennzeichnet, dass** sie einen im wesentlichen T-förmigen Grundriss aufweist.

3. Flexible Leiterplatte (11, 75) nach einem der vorhergehenden Ansprüche,
**dadurch gekennzeichnet, dass** die Metallisierungsschicht (78, 79) und die Abschirmschicht (76, 80) aus demselben leitfähigen Material bestehen.

4. Flexible Leiterplatte (11, 75) nach einem der vorhergehenden Ansprüche,
**dadurch gekennzeichnet, dass** die leitfähigen Strukturen der Metallisierungsschicht (79) und die Abschirmschicht (80) durch Entfernen von leitfähigem Material aus derselben Schicht erzeugt sind.

5. Flexible Leiterplatte (11, 75) nach einem der vorhergehenden Ansprüche,
**dadurch gekennzeichnet, dass** zur Abschirmung gegen elektromagnetische Störeinflüsse eine Schicht vorgesehen ist, die Gold beinhaltet.

6. Schaltung, die auf einer flexiblen Leiterplatte (11, 75) aufgebaut ist, welche eine Trägerschicht (77), eine Metallisierungsschicht (78, 79) und eine Abschirmschicht (76, 80) zur Abschirmung gegen elektromagnetische Störeinflüsse umfasst, wobei die Leiterplatte (11, 75) in mindestens einem Schaltungsbereich (2, 3) elektronische Bauelemente (4, 10) trägt und in mindestens drei unterschiedlichen Biegebereichen (30, 31, 32, 33) um je eine Biegeachse (35) biegbar ist, wobei zwei Biegeachsen (35) parallel zueinander und senkrecht zu der dritten Biegeachse (35) stehen, und wobei die Abschirmschicht (76, 80)sich mindestens über die drei Biegebereiche (31, 32, 33) erstreckt,
**dadurch gekennzeichnet, dass** die Leiterplatte (11, 75) in zwei durch einen weiteren Biegebereich (30) getrennten Schaltungsbereichen (2, 3) elektronische Bauelemente (4, 10) trägt, dass sich die Abschirmschicht (76, 80) weiterhin über drei unterschiedliche durch Biegebereiche (31, 32, 33) von den Schaltungsbereichen (2, 3) und voneinander getrennte Leiterplattenbereiche (5, 6, 7) erstreckt, und dass die Leiterplatte (11, 75) derart in den Biegebereichen (30, 31, 32, 33) gebogen ist, dass die Schaltungsbereiche (2, 3) übereinander angeordnet und durch die Abschirmschicht (76, 80) in mindestens fünf Raumrichtungen gegen elektromagnetische Störeinflüsse abgeschirmt sind, indem einer der Leiterplattenbereiche (6, 5, 7) oberhalb und die beiden anderen Leiterplattenbereiche (6, 5, 7) unterhalb der Schaltungsbereiche (2,3) angeordnet sind, so dass die Leiterplattenbereiche (6, 5, 7) Außenwände eines umschlossenen Schaltungsvolumens (41) in zwei zueinander fluchtenden Raumrichtungen und die Biegebereiche (30, 31, 32, 33) Außenwände in davon abweichenden Raumrichtungen bilden.

7. Schaltung nach Anspruch 6,
**dadurch gekennzeichnet, dass** die Metallisierungsschicht (78, 79) und die Abschirmschicht (76, 80) aus demselben leitfähigen Material bestehen.

8. Schaltung nach einem der Ansprüche 6 oder 7,
**dadurch gekennzeichnet, dass** die leitfähigen Strukturen der Metallisierungsschicht (79) und die Abschirmschicht (80) durch Entfernen von leitfähigem Material aus derselben leitfähigen Schicht erzeugt sind.

9. Schaltung nach einem der vorhergehenden Ansprüche 6 bis 8,
**dadurch gekennzeichnet, dass** zur Abschirmung gegen elektromagnetische Störeinflüsse eine Schicht vorgesehen ist, die Gold beinhaltet.

10. Schaltung nach einem der Ansprüche 6 bis 9,
**dadurch gekennzeichnet, dass** die Leiterplatte (11, 75) derart in den Biegebereichen (30, 31, 32, 33) gebogen ist, dass die Leiterplattenbereiche (5, 6, 7) ein zwei Seiten der Schaltungsbereiche (2, 3) umfassendes Schaltungsvolumen (41) umgrenzen, und dass das Schaltungsvolumen (41) ausgegossen ist.

11. Schaltung nach Anspruch 10,
**dadurch gekennzeichnet, dass** das Schaltungsvolumen (41) mit Epoxidharz ausgegossen ist.

12. Hörhilfe mit einer Schaltung nach einem der Ansprüche 6 bis 11.

## Claims

1. Flexible printed circuit board (11, 75) comprising a mount layer (77), a metallization layer (78, 79) and a shielding layer (76, 80) for shielding against electromagnetic interference influences, wherein the printed circuit board (11, 75) can be bent in at least three different bending areas (31, 32, 33) about a respective bending axis (35), wherein two bending axes (35) are parallel to one another and at right angles to the third bending axis (35), and wherein the shielding layer (76, 80) extends at least over the three bending areas (31, 32, 33), **characterized in that** the printed circuit board (11, 75) bears electronic components (4, 10) in two circuit areas (2, 3) separated by a further bending area (30) and **in that** the shielding area (76, 80) furthermore extends at least over three different printed circuit board areas (6, 5, 7) separated from the circuit areas (2, 3) and from one another by bending areas (31, 32, 33), and **in that** the printed circuit board (11, 75) is embodied in such a way that it can be bent in the bending areas (30, 31, 32, 33) in such a way that the circuit areas (2, 3) are arranged above one another and are shielded in at least five spatial directions against electromagnetic interference influences by the shielding layer (76, 80) by virtue of one of the printed circuit board areas (6, 5, 7) being arranged above and the two other printed circuit board areas (6, 5, 7) being arranged below the circuit areas (2, 3) so that the printed circuit board areas (6, 5, 7) form outer walls of a surrounded circuit volume (41) in two spatial directions in alignment with one another and the bending areas (30, 31, 32, 33) form outer walls in spatial directions deviating therefrom.

2. Flexible printed circuit board (11) according to Claim 1, **characterized in that** said printed circuit board has a substantially T-shaped outline.

3. Flexible printed circuit board (11, 75) according to either of the preceding claims, **characterized in that** the metallization layer (78, 79) and the shielding layer (76, 80) are composed of the same conductive material.

4. Flexible printed circuit board (11, 75) according to one of the preceding claims, **characterized in that** the conductive structures of the metallization layer (79) and the shielding layer (80) are produced by removal of conductive material from the same layer.

5. Flexible printed circuit board (11, 75) according to one of the preceding claims, **characterized in that** a layer containing gold is provided for shielding against electromagnetic interference influences.

6. Circuit, which is disposed on a flexible printed circuit board (11, 75), which comprises a mount layer (77), a metallization layer (78, 79) and a shielding layer (76, 80) for shielding against electromagnetic interference influences, wherein the printed circuit board (11, 75) bears electronic components (4, 10) in at least one circuit area (2, 3) and can be bent in at least three different bending areas (30, 31, 32, 33) about a respective bending axis (35), wherein two bending axes (35) are parallel to one another and at right angles to the third bending axis (35), and wherein the shielding layer (76, 80) extends at least over the three bending areas (31, 32, 33), **characterized in that** the printed circuit board (11, 75) bears electronic components (4, 10) in two circuit areas (2, 3) separated by a further bending area (30), **in that** the shielding layer (76, 80) furthermore extends over three different printed circuit board areas (5, 6, 7) separated from the circuit areas (2, 3) and from one another by bending areas (31, 32, 33), and **in that** the printed circuit board (11, 75) is bent in the bending areas (30, 31, 32, 33) in such a way that the circuit areas (2, 3) are arranged above one another and are shielded in at least five spatial directions against electromagnetic interference influences by the shielding layer (76, 80) by virtue of one of the printed circuit board areas (6, 5, 7) being arranged above and the two other printed circuit board areas (6, 5, 7) being arranged below the circuit areas (2, 3) so that the printed circuit board areas (6, 5, 7) form outer walls of a surrounded circuit volume (41) in two spatial directions in alignment with one another and the bending areas (30, 31, 32, 33) form outer walls in spatial directions deviating therefrom.

7. Circuit according to Claim 6, **characterized in that** the metallization layer (78, 79) and the shielding layer (76, 80) are composed of the same conductive material.

8. Circuit according to either of Claims 6 and 7, **characterized in that** the conductive structures of the metallization layer (79) and the shielding layer (80) are produced by removal of conductive material from the same conductive layer.

9. Circuit according to one of the preceding Claims 6 to 8, **characterized in that** a layer containing gold is provided for shielding against electromagnetic interference influences.

10. Circuit according to one of Claims 6 to 9, **characterized in that** the printed circuit board (11, 75) is bent in the bending areas (30, 31, 32, 33) in such a way that the printed circuit board areas (5, 6, 7) bound a circuit volume (41) including two sides of the circuit areas (2, 3) and **in that** the circuit volume (41) is encapsulated.

11. Circuit according to Claim 10, **characterized in that** the circuit volume (41) is encapsulated with epoxy resin.

12. Hearing aid, comprising a circuit according to one of Claims 6 to 11.

## Revendications

1. Carte de circuit imprimé souple (11, 75) comprenant une couche porteuse (77), une couche de métallisation (78, 79) et une couche de blindage (76, 80) destinée à assurer le blindage contre des interférences électromagnétiques, la carte de circuit imprimé (11, 75) étant flexible dans au moins trois différentes zones de flexion (31, 32, 33) autour à chaque fois d'un axe de flexion (35), deux axes de flexion (35) étant placés en parallèle l'un de l'autre et à la perpendiculaire du troisième axe de flexion (35) et la couche de blindage (76, 80) s'étendant sur au moins les trois zones de flexion (31, 32, 33), **caractérisée en ce que** dans deux zones de circuit (2, 3) séparées par une zone de flexion (30) supplémentaire, la carte de circuit imprimé (11, 75) porte des composants électroniques (4, 10) et **en ce que** la couche de blindage (76, 80) s'étend par ailleurs au moins sur trois différentes zones de carte de circuit imprimé (6, 5, 7) séparées des zones de circuit (2, 3) et séparées les unes des autres par des zones de flexion (31, 32, 33) et **en ce que** la carte de circuit imprimé (11, 75) est réalisée de sorte à pouvoir être infléchie dans les zones de flexion (30, 31, 32, 33) de manière à ce que les zones de circuit (2, 3) soient placées en superposition et soient blindées par la couche de blindage (76, 80) dans au moins cinq directions spatiales contre des interférences électromagnétiques, par le fait que l'une des zones de circuit imprimé (6, 5, 7) est placée au-dessus et les deux autres zones de carte de circuit imprimé (6, 5, 7) sont placées en-dessous des zones de carte de circuit (2, 3), de sorte que les zones de circuit imprimé (6, 5, 7) forment des parois extérieures d'un volume de circuit (41) ceint dans deux directions spatiales alignées l'une sur l'autre et les zones de flexion (30, 31, 32, 33) forment des parois extérieures dans des directions spatiales divergentes de celles-ci.

2. Carte de circuit imprimé souple (11) selon la revendication 1, **caractérisée en ce qu'**elle présente une projection horizontale sensiblement en forme de T.

3. Carte de circuit imprimé souple (11, 75) selon l'une quelconque des revendications précédentes, **caractérisée en ce que** la couche de métallisation (78, 79) et la couche de blindage (76, 80) sont constituées de la même matière conductrice.

4. Carte de circuit imprimé souple (11, 75) selon l'une quelconque des revendications précédentes, **caractérisée** en ce queles structures conductrices de la couche de métallisation (79) et la couche de blindage (80) sont produites par retrait de matière conductrice de la même couche.

5. Carte de circuit imprimé souple (11, 75) selon l'une quelconque des revendications précédentes, **caractérisée en ce que** pour le blindage contre des interférences électromagnétiques, il est prévu une couche qui contient de l'or.

6. Circuit, lequel est conçu sur une carte de circuit imprimé (11, 75) souple, laquelle comprend une couche porteuse (77), une couche de métallisation (78, 79) et une couche de blindage (76, 80), destinée à assurer le blindage contre des interférences électromagnétiques, dans au moins une zone de circuit (2, 3), la carte de circuit imprimé (11, 75) portant des composants électroniques (4, 10) et étant flexible dans au moins trois différentes zones de flexion (30, 31, 32, 33) autour à chaque fois d'un axe de flexion (35), deux axes de flexion (35) étant placés en parallèle l'un de l'autre et à la perpendiculaire du troisième axe de flexion (35) et la couche de blindage (76, 80) s'étendant sur au moins les trois zones de flexion (31, 32, 33), **caractérisé en ce que** dans deux zones de circuit (2, 3) séparées par une zone de flexion (30) supplémentaire, la carte de circuit imprimé (11, 75) porte des composants électroniques (4, 10), **en ce que** la couche de blindage (76, 80) s'étend par ailleurs sur trois différentes zones de carte de circuit imprimé (5, 6, 7) séparées des zones de circuit (2, 3) et séparées les unes des autres par des zones de flexion (31, 32, 33) et **en ce que** la carte de circuit imprimé (11, 75) est infléchie dans les zones de flexion (30, 31, 32, 33), de manière à ce que les zones de circuit (2, 3) soient placées en superposition et soient blindées par la couche de blindage (76, 80) dans au moins cinq directions spatiales contre des interférences électromagnétiques, par le fait que l'une des zones de carte de circuit imprimé (6, 5, 7) est placée au-dessus et les deux autres zones de carte de circuit imprimé (6, 5, 7) sont placées en-dessous des zones de circuit (2, 3), de sorte que les zones de carte de circuit imprimé (6, 5, 7) forment des parois extérieures d'un volume de circuit (41) ceint dans deux directions spatiales alignées l'une sur l'autre et les zones de flexion (30, 31, 32, 33) forment des parois extérieures dans des directions spatiales divergentes de celles-ci.

7. Circuit selon la revendication 6, **caractérisé en ce que** la couche de métallisation (78, 79) et la couche de blindage (76, 80) sont constituées de la même matière conductrice.

8. Circuit selon l'une quelconque des revendications 6 ou 7, **caractérisé en ce que** les structures conductrices de la couche de métallisation (79) et la couche de blindage (80) sont produites par retrait de matière conductrice de la même couche conductrice.

9. Circuit selon l'une quelconque des revendications précédentes 6 à 8, **caractérisé en ce que** pour le blindage contre des interférences électromagnétiques, il est prévu une couche qui contient de l'or.

10. Circuit selon l'une quelconque des revendications 6 à 9, **caractérisé en ce que** la carte de circuit imprimé (11, 75) est infléchie dans les zones de flexion (30, 31, 32, 33) de sorte que les zones de carte de circuit imprimé (5, 6, 7) délimitent un volume de circuit (41) comprenant deux faces des zones de circuit (2, 3) et **en ce que** le volume de circuit (41) est surmoulé.

11. Circuit selon la revendication 10, **caractérisé en ce que** le volume de circuit (41) est surmoulé de résine époxy.

12. Aide auditive, pourvue d'un circuit selon l'une quelconque des revendications 6 à 11.
